# EUROPEAN PATENT SPECIFICATION

(11) **EP 2 279 821 B1**
(45) Date of publication and mention of the grant of the patent: **16.05.2018**
(21) Application number: 10007162.0
(22) Date of filing: 12.07.2010
(51) Int. Cl.: B23K 3/06, B41F 15/42, H05K 3/12

(54) **Fluid supply apparatus and fluid supply method**
Flüssigkeitsversorgungsvorrichtung und Flüssigkeitsversorgungsverfahren
Appareil d'alimentation en fluide et procédé d'alimentation en fluide

(30) Priority: 29.07.2009 JP 2009176216
(43) Date of publication of application: 02.02.2011
(73) Proprietor: Juki Automation Systems Corporation, Tokyo 206-8551 (JP)
(72) Inventor: Watanabe, Akihiko, Tokyo 108-0075 (JP); Noda, Tsutomu, Kuki-shi, Saitama 346-0035 (JP)
(74) Representative: Müller Hoffmann & Partner

(56) References cited:
- EP-A2- 0 274 620
- EP-A2- 0 330 928
- JP-A- 2004 306 102
- US-A- 5 348 585
- US-B1- 6 454 154

## Description

### Background of the Invention

The present invention relates to a fluid supply apparatus, a fluid applying apparatus, and a fluid supply method for supplying a fluid such as solder that is to be applied to a printed circuit board.

### Description of the Related Art

In the past, there has been known a solder printer that applies solder paste to a land and the like of a printed circuit board to form a solder pattern. In the solder printer, a solder supply apparatus that supplies solder paste is incorporated. Such a solder supply apparatus is disclosed in Japanese Patent Application Laid-open No. 2004-306102 (hereinafter, referred to as Patent Document 1), for example (see, Fig. 2 and the like of Patent Document 1).

In the solder supply apparatus disclosed in Patent Document 1, a supply assembly is used. The supply assembly is constituted of a supply container that contains solder, a supply container member that stores and fixes the supply container in position, and a discharge adaptor that is inserted in an opening portion of the supply container. In addition, to the solder supply apparatus, a drive mechanism for pressing the supply container member is provided.

The supply assembly is mounted on the solder supply apparatus so that the opening portion side of the supply container is faced downward. At the time of supplying solder, by the drive mechanism, the supply container member is pressed and moved to the discharge adaptor inserted. The discharge adaptor is fixed in position, so when the supply container member is moved, the discharge adaptor is caused to enter the supply container fixed by the supply container member, resulting in application of a pressure to the solder in the supply container. The discharge adaptor has a discharge opening. Therefore, the solder subjected to the pressure is supplied to a printed circuit board and the like through the discharge opening.

### Summary of the Invention

In the solder supply apparatus disclosed in Patent Document 1, however, a drive mechanism capable of sufficiently pressing and moving the supply container member is needed in order to reliably supply the solder. To serve the need, a large drive mechanism that is provided with a motor or the like having a large output is used, which makes it difficult to miniaturize the solder supply apparatus.

In view of the above-mentioned circumstances, it is desirable to provide a fluid supply apparatus, a fluid applying apparatus, and a fluid supply method capable of realizing the miniaturization and reliably supplying a fluid.

The above objects are achieved by the claimed matter according to the independent claims.

According to an embodiment of the present invention, there is provided a fluid supply apparatus including a piston, a piston support portion, a container support portion, and a drive mechanism.

The piston has a through hole.

The piston support portion supports the piston.

The container support portion is capable of supporting a container in which a fluid is contained.

The drive mechanism drives at least one of the container support portion and the piston support portion so that the piston is inserted into the container while the container and the piston are relatively rotated to discharge the fluid from the container through the through hole of the piston.

In the fluid supply apparatus, the piston is inserted into the container with the container and the piston being relatively rotated, resulting in reduction in resistance of the piston with respect to the container at the time when the piston is inserted. Thus, for example, even with the small drive mechanism provided with a small motor whose output is small, the piston can be reliably inserted into the container, with the result that the fluid can be positively supplied.

The drive mechanism may drive at least one of the container support portion and the piston support portion so that the piston is relatively moved in a direction in which the piston is removed from the container to adjust a discharge amount of the fluid.

When the piston is relatively moved in the direction in which the container is removed from the container, the pressure applied to the fluid in the container becomes small. Therefore, the piston is moved during the discharge of the fluid, and the discharge of the fluid is stopped as described above, which can adjust the discharge amount of the fluid. Since the resistance of the piston with respect to the container at the time when the piston is moved is small, the piston can be easily moved as described above.

The piston may include a seal member provided at an end portion of the piston. The seal member has a tapered outer circumferential surface whose outer circumference is increased in diameter in a direction in which the piston is inserted.

Since the resistance of the piston with respect to the container at the time when the piston is inserted is small, the seal member can be provided at the end portion of the piston. With the seal member, the fluid in the container can be sufficiently scraped off and discharged.

The fluid supply apparatus of the invention further includes a nozzle and an opening and closing mechanism.

The nozzle has an inside flow path that is communicated with the through hole.

The opening and closing mechanism is capable of opening and closing the inside flow path.

In the fluid supply apparatus, the fluid is discharged through the inside flow path of the nozzle. The inside flow path is closed by the opening and closing mechanism when the fluid is discharged, thereby making it easier to remove the fluid from the nozzle. In addition, by closing the inside flow path of the nozzle at a desired timing, the supply amount of the fluid can be adjusted.

The nozzle includes a discharge end portion including a tapered surface whose outer circumference is decreased in diameter in a direction in which the fluid is discharged. In this case, the opening and closing mechanism may close the inside flow path by pressing the discharge end portion.

Since the discharge end portion from which the fluid is discharged has the tapered surface, the fluid is easily separated from the nozzle when the inside flow path is closed by the opening and closing mechanism.

The opening and closing mechanism may include a pair of opening and closing members.

The pair of opening and closing members presses the nozzle with the nozzle being sandwiched therebetween. The pair of opening and closing members each has a pressing end portion and a cutout. The pressing end portion presses the nozzle, and the cutout is formed at the pressing end portion.

In the fluid supply apparatus, the nozzle is pressed by the pair of opening and closing members while being sandwiched therebetween, thereby closing the inside flow path of the nozzle. At the pressing end portion of each of the pair of the opening and closing members, the cutout is formed. At the time when the inside flow path is closed, the deformation of the nozzle is suppressed by the size of the cutout. The size of the cutout may be set as appropriate within the range in which the inside flow path is closed.

As described above, according to the embodiments of the present invention, the fluid supply apparatus, the fluid applying apparatus, and the fluid supply method capable of realizing the miniaturization and capable of reliably supplying the fluid can be provided.

These and other objects, features and advantages of the present invention will become more apparent in light of the following detailed description of best mode embodiments thereof, as illustrated in the accompanying drawings.

### Brief Description of Drawings

Fig. 1 is a schematic diagram showing a structure of a fluid applying apparatus according to an embodiment of the present invention;
Fig. 2 is a schematic diagram showing a structure of a substrate support mechanism shown in Fig. 1;
Fig. 3 is a schematic perspective view showing a fluid supply apparatus and a squeegee mechanism according to the embodiment;
Fig. 4 is a schematic front view showing the fluid supply apparatus and the squeegee mechanism shown in Fig. 3;
Fig. 5 is a schematic side view showing the fluid supply apparatus and the squeegee mechanism shown in Fig. 3;
Fig. 6 is a schematic side view showing the fluid supply apparatus and the squeegee mechanism shown in Fig. 3;
Fig. 7 is a schematic top view showing the fluid supply apparatus and the squeegee mechanism shown in Fig. 3;
Fig. 8 is a schematic cross-sectional view showing a piston according to the embodiment;
Figs. 9 are schematic cross-sectional views each showing an end portion of the piston fixed by a piston support portion, that is opposite to an end portion on the side of the container;
Figs. 10 are enlarged schematic views each showing a nozzle and opening and closing members shown in Figs. 9;
Fig. 11 is a schematic perspective view showing a squeegee according to the embodiment;
Fig. 12 is a schematic top view of the squeegee shown in Fig. 11 when viewed from above;
Fig. 13 is a block diagram showing a structure of a control system of a fluid applying apparatus according to the embodiment;
Fig. 14 is a block diagram showing a control system of the fluid supply apparatus and the squeegee mechanism in the block diagram shown in Fig. 13;
Fig. 15 is a flowchart showing an operation of the fluid applying apparatus according to the embodiment;
Fig. 16 is a schematic cross-sectional view showing a seal member and the piston inserted into the container;
Fig. 17 is a top view schematically showing a motion of solder when the solder is applied with the squeegee; and
Fig. 18 is a perspective view showing a modified example of the drive mechanism of the fluid applying apparatus according to the embodiment.

### Description of Preferred Embodiments

Hereinafter, an embodiment of the present invention will be described with reference to the drawings.

### (Structure of fluid applying apparatus)

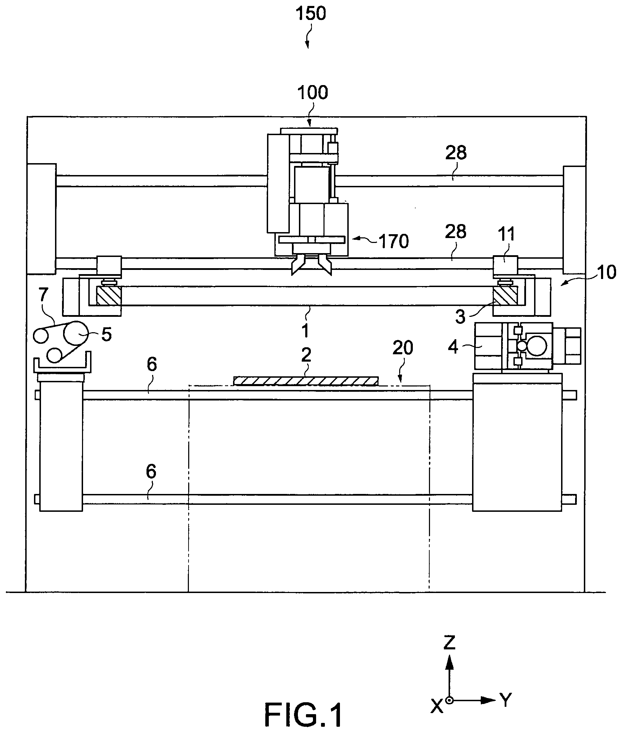

Fig. 1 is a schematic diagram showing a structure of a fluid applying apparatus according to an embodiment of the present invention. A fluid applying apparatus 150 is an apparatus for supplying solder as a fluid to a substrate 2 through a screen 1. The fluid applying apparatus 150 includes a fluid supply apparatus 100, a squeegee mechanism 170, a fixation mechanism 10 that fixes the screen 1 in position, and a substrate support mechanism 20 that supports the substrate 2.

The fixation mechanism 10 includes a plurality of clamps 11 that hold end portions 3 of the screen 1. The screen 1 is fixed in position with the plurality of clamps 11. The screen 1 is fixed below the fluid supply apparatus 100 and the squeegee mechanism 170 so as to be opposed thereto. Further, the screen 1 has a pattern hole (not shown).

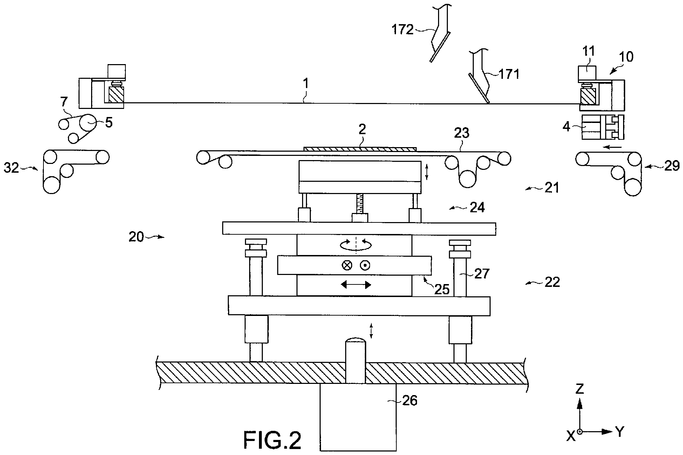

Fig. 2 is a schematic diagram showing a structure of the substrate support mechanism 20. The support mechanism 20 includes a stage mechanism 21 and a stage movement mechanism 22 that moves the stage mechanism 21. The stage mechanism 21 includes a conveyor belt 23 and an adsorption block mechanism 24 capable of being moved up and down. The adsorption block mechanism 24 supports the substrate 2 that is conveyed by the conveyor belt 23 and causes the substrate 2 to move above the conveyor belt 23.

The stage movement mechanism 22 includes a movement unit 25 that moves the stage mechanism 21 in a surface direction of the substrate 2 (X direction and Y direction in Fig. 2) and rotates the stage mechanism 21 about the Z axis in Fig. 2. In addition, the stage movement mechanism 22 includes an air cylinder 26. The air cylinder 26 moves the stage mechanism 21 in a vertical direction (Z direction). Further, the stage movement mechanism 22 includes a plurality of stoppers 27 provided in the perimeter of the movement unit 25.

As shown in Fig. 1, the fluid applying apparatus 150 includes a camera portion 4 and a cleaning unit 5. The camera portion 4 and the cleaning unit 5 are capable of being moved along guide rails 6. The camera portion 4 recognizes an alignment mark (not shown) given on the substrate 2 in order to position the substrate 2. The cleaning unit 5 is provided with cleaning paper 7, with which a lower surface (surface on the substrate 2 side) of the screen 1 is subjected to cleaning.

### (Structure of fluid supply apparatus)

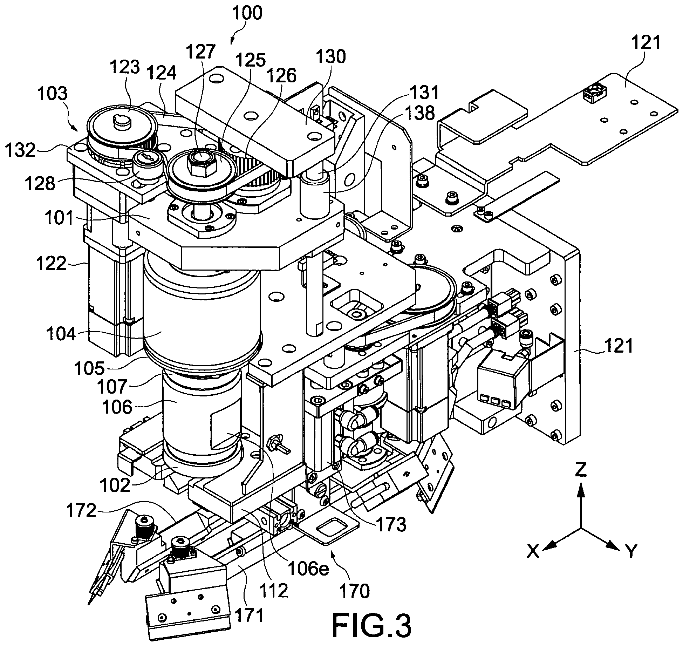

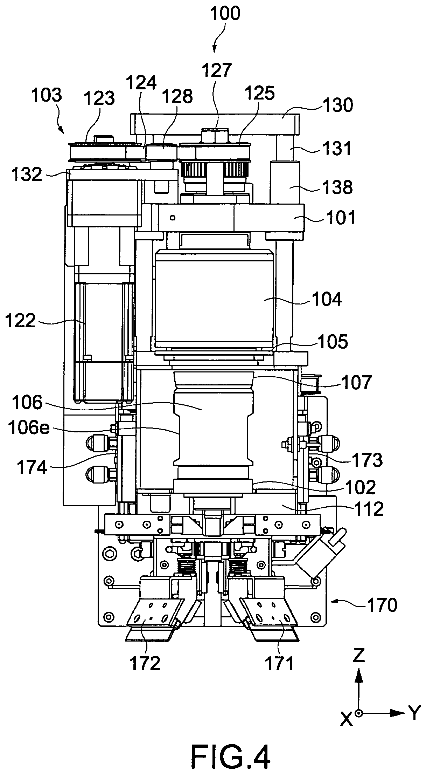

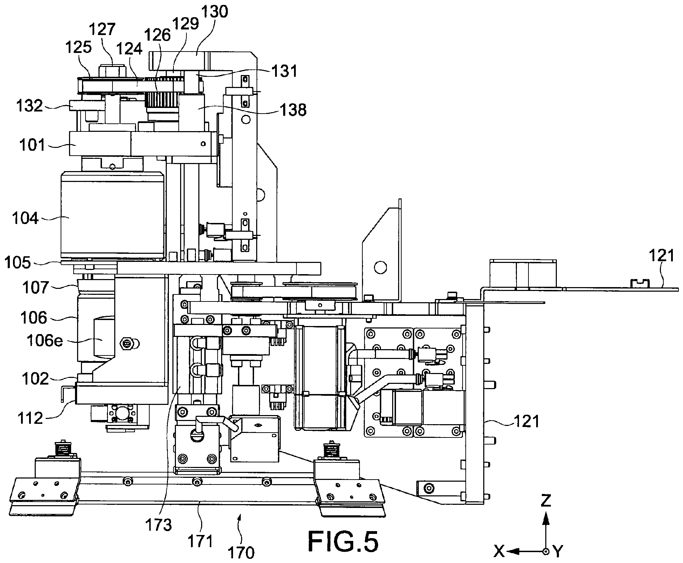

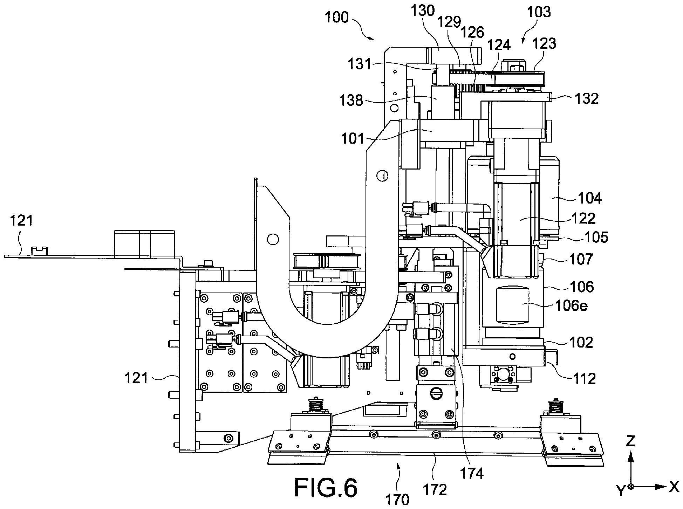

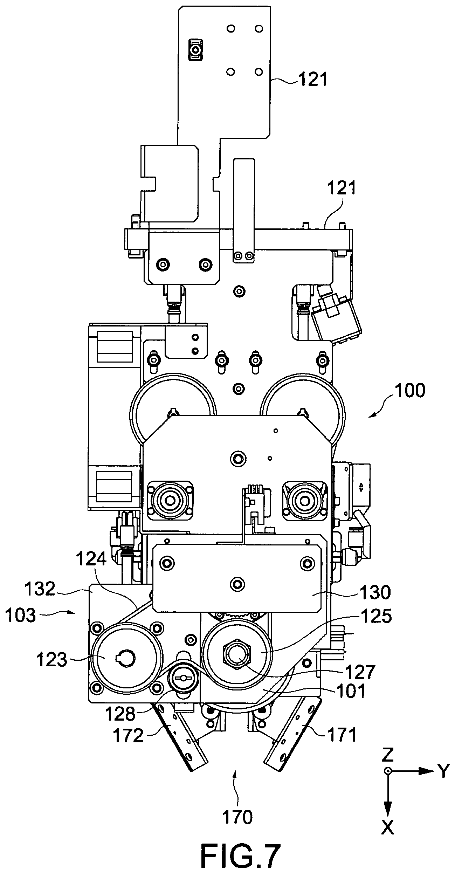

Fig. 3 is a schematic perspective view showing the fluid supply apparatus 100 and the squeegee mechanism 170 according to this embodiment. Figs. 4 to 7 are a front view (Fig. 4), side views (Figs. 5 and 6), and a top view (Fig. 7) schematically showing the fluid supply apparatus 100 and the squeegee mechanism 170 shown in Fig. 3.

The fluid supply apparatus 100 includes a container support portion 104, a piston support portion 102, and a drive mechanism 103 that drives the container support portion 104 and the piston support portion 102.

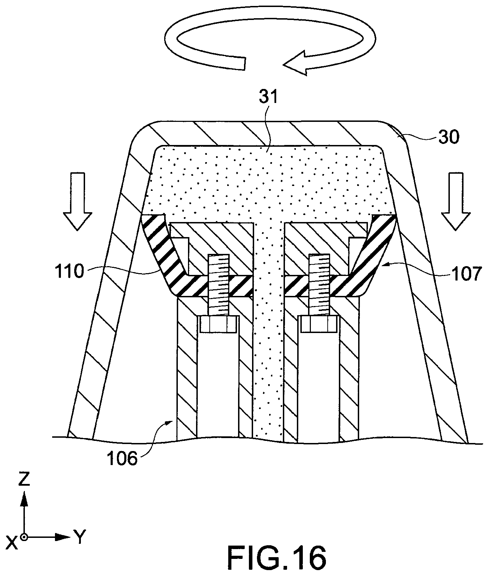

Like the supply apparatus disclosed in Patent Document 1, the container support portion 104 is capable of holding commercially available solder and a container (see, container 30 shown in Fig. 16) in which the solder is contained. Specifically, the container support portion 104 is formed to have a shape that covers the bottom surface (surface of an upper portion in the figure) and the side surface of the container. The container support portion 104 is disposed below a support block 101 so as to be rotatable with respect to the support block 101.

The container and the container support portion 104 each have an opening on one side. The container is fixed in position by a ring-shaped fixation member 105 provided at the opening of the container support portion 104. By rotating the container support portion 104, the container is integrally rotated with the container support portion 104. The container support portion 104 is supported by the support block 101 so that the opening of the container is faced downward (toward the side on which the substrate 2 is disposed). The container support portion 104 is formed so as to fit to the shape of the container, and is made of metal such as aluminum, stainless steel, and iron.

The piston support portion 102 is fixed on a piston support block 112 that is opposed to the support block 101 from below. To the piston support portion 102, a piston 106 capable of being inserted into the container is fixed.

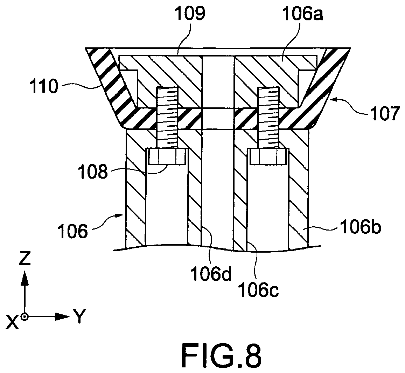

Fig. 8 is a schematic cross-sectional view showing the piston 106. The piston 106 has a through hole 106d that is extended in a direction in which the piston 106 is inserted (Z direction in Fig. 8). The through hole 106d serves as a flow path of the solder. The through hole 106d is formed to be positioned at approximately the center of an end surface 109 of the piston 106 that is inserted into the container.

To an end portion 106a of the piston 106 which is inserted into the container, a seal member 107 is provided so as to surround the end portion 106a. The seal member 107 is fitted in the container. The end portion 106a of the piston 106 is capable of being detached from a piston main body 106b and is screwed with a screw 108 provided to a screw hole 106c in the piston main body 106b. The seal member 107 is fixed by being sandwiched between the piston main body 106b and the end portion 106a.

As shown in Fig. 8, the seal member 107 has a tapered outer circumferential surface 110 whose outer circumference is increased in diameter in a direction in which the piston 106 is fitted (Z direction). As the seal member 107, a material having elasticity such as urethane and silicon is used. As the piston 106, a metal such as aluminum, stainless steel, and iron is used. The piston 106 and the seal member 107 are formed so as to fit to the shape of the container. It should be noted that an O ring or the like may be used as the seal member 107. Further, in this embodiment, although the end surface 109 of the piston 106 is flat, the end surface 109 may have a concave shape inclined toward the through hole 106d that is formed at approximately the center of the end surface 109.

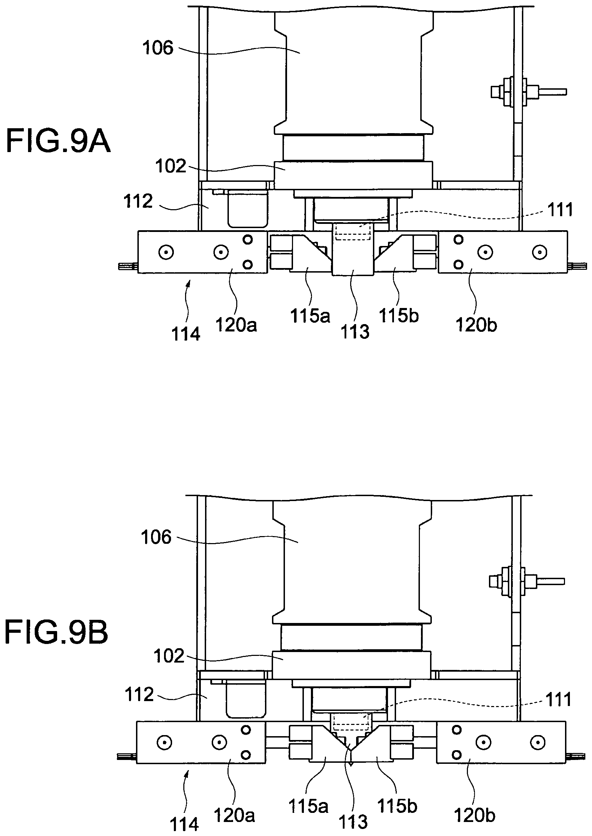

Figs. 9A and 9B are schematic cross-sectional views each showing an end portion 111 on the side opposite to the end portion 106a of the piston 106 fixed to the piston support portion 102. The end portion 111 on the side opposite to the end portion 106a has a tube shape. The inside of the tube-shaped end portion 111 functions as a part of the through hole 106d. The piston support portion 102 has a through hole (not shown) through which the end portion 111 passes.

To the end portion 111, a nozzle 113 made of silicon rubber or the like is attached. The inside flow path of the nozzle 113 is communicated with the through hole 106d. Through the through hole 106d of the piston 106 and the inside flow path of the nozzle 113, the solder in the container is discharged to the outside.

As shown in Figs. 9A and 9B, below the piston support block 112, an opening and closing mechanism 114 that sandwiches the nozzle 113 is provided. The opening and closing mechanism 114 is constituted of a pair of opening and closing members 115a and 115b and air cylinders 120a and 120b connected to the opening and closing members 115a and 115b, respectively. The opening and closing members 115a and 115b are closed by the air cylinders 120a and 120b, and the nozzle 113 is pressed as shown in Fig. 9B. As a result, the inside flow path of the nozzle 113 is closed.

By closing the inside flow path of the nozzle 113 as described above when the solder is discharged from the nozzle 113, the solder discharged is easily removed from the nozzle 113. In addition, by closing the inside flow path of the nozzle 113 at a desired timing, the amount of supply of the solder can be adjusted. Further, for example, the inside flow path is closed during a time period when the solder is not discharged, thereby making it possible to prevent air from getting into the container. Thus, it is possible to prevent the solder from being oxidized. It is also possible to prevent a foreign matter from getting into the container.

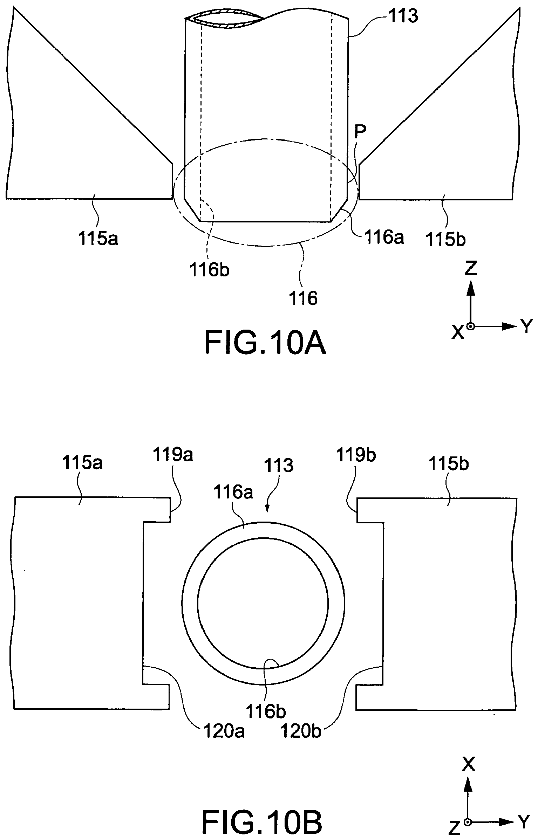

Figs. 10A and 10B are enlarged schematic views each showing the nozzle 113 and the opening and closing members 115a and 115b. As shown in Fig. 10A, a discharge end portion 116 of the nozzle 113 (portion surrounded by a dashed-dotted line of Fig. 10A) from which the solder is discharged has a tapered surface 116a whose outer circumference has a diameter decreased in a direction in which the solder is discharged (in the negative Z direction). The opening and closing members 115a and 115b press a part P (outer circumferential side surface) immediately above the tapered surface 116a, thereby making it easier to remove the solder from the nozzle 113. This may be because the contact area of the nozzle 113 with the solder is reduced by forming the tapered surface 116a.

Fig. 10B shows the pair of the opening and closing members 115a and 115b when viewed from below. In the figure, the nozzle 113 and the inside flow path 116b are shown between the opening and closing members 115a and 115b. As shown in Fig. 10B, on pressing end potions 119a and 119b of the opening and closing members 115a and 115b, cutouts 120a and 120b are formed, respectively. The pressing end portions 119a and 119b press the nozzle 113. Therefore, when the opening and closing members 115a and 115b press the nozzle 113 (see, Fig. 9B), the nozzle 113 can be suppressed from being deformed by the sizes of the cutouts 120a and 120b. With this structure, it is possible to prevent the nozzle 113 from being deteriorated and damaged. In addition, it is also possible to prevent plastic deformation of the nozzle 113 pressed repeatedly by the opening and closing members 115a and 115b, which can avoid the case where the inside flow path 116b is not secured even in a state where the opening and closing members 115a and 115b are opened.

The sizes of the cutouts 120a and 120b may be arbitrarily set within a range in which the inside flow path 116b is closed when the nozzle 113 is pressed. In Fig. 10B, the shape of the cutouts 120a and 120b is set to be rectangle, but is not limited thereto. The shape of the cutouts may be set to a circular arc or an ellipsoidal arc.

In addition, as shown in Figs. 3 to 6, on the side surface of the piston 106, a planar portion 106e is formed. The planner portion has a planner surface. The planar portion 106e is irradiated with laser light or the like, and reflected light is detected. As a result, whether the piston 106 is properly disposed can be checked. Further, the planar portion 106e makes it easier to carry the piston 106.

It should be noted that in Figs. 3 to 6, the state where the piston 106 and the seal member 107 are not fitted into the container is shown in order to make the piston 106 and the seal member 107 more visible. In this state, the container support portion 104 and the piston support portion 102 are driven, and the piston 106 may be fitted into the container. Alternatively, the piston 106 is fitted into the container stored in the container support portion 104, and in this state, the container support portion 104 and the piston 106 may be disposed on the support block 101 and the piston support portion 102, respectively.

The drive mechanism 103 includes a motor 122, a driving pulley 123, and two driven pulleys. The driving pulley 123 is provided to a rotation shaft of the motor 122. The two driven pulleys are connected to the driving pulley 123 through a belt 124. The two driven pulleys are constituted of a rotary drive pulley 125 and a vertical drive pulley 126. The motor 122 is disposed below a support plate 132 and supported by the supported plate 132. The support plate 132 is fixed to the support block 101 directly or indirectly. A drive shaft (not shown) of the motor 122 is connected to the driving pulley 123 while penetrating the support plate 132.

As shown in Figs. 3 to 6, the driving pulley 123 is disposed on the support plate 132. The rotary drive pulley 125 and the vertical drive pulley 126 are disposed on the support block 101. The rotary drive pulley 125 is disposed above the container support portion 104, and a rotation shaft 127 of the rotary drive pulley 125 is connected to the container support portion 104. The vertical drive pulley 126 is disposed behind the rotary drive pulley 125. The cogs of the vertical drive pulley 126 and the cogs of the rotary drive pulley 125 are engaged with each other. In addition, between the driving pulley 123 and the rotary drive pulley 125, a tension member 128 that prevents the slack of the belt 124 is provided.

As the rotation shaft of the vertical drive pulley 126, a lead screw 129 is mounted. The upper end of the lead screw 129 is fixed to a frame 130. To the lower portion of the frame 130, for example, two guide shafts 131 are connected in a vertical direction. To the two guide shafts 131, the drive mechanism 103, the support plate 132, the support block 101, and the container are integrally provided through an attachment portion 138 so as to be vertically movable. That is, when the vertical drive pulley 126 is rotated, the drive mechanism 103, the support plate 132, the support block 101, and the container are integrally moved with respect to the frame 130 in the vertical direction. Thus, the drive mechanism 103, the support plate 132, the support block 101, and the container are integrally moved with respect to the piston 106 in the vertical direction. As the lead screw 129, for example, a trapezoidal screw or a ball screw may be used.

As shown in Figs. 3 to 7, the squeegee mechanism 170 in this embodiment is provided to the lower portion of the fluid supply apparatus 100 and is capable of being moved integrally with the fluid supply apparatus 100 along guide rails 28 shown in Fig. 1. The fluid supply apparatus 100 and the squeegee mechanism 170 are connected to the guide rails 28 by a connection member 121 provided on the back surface side thereof.

The squeegee mechanism 170 includes a pair of squeegees 171 and 172. To the squeegees 171 and 172, air cylinders 173 and 174 are connected, respectively. By the air cylinders 173 and 174, the squeegees 171 and 172 are movable in the vertical direction. The squeegees 171 and 172 have the similar structure, so the squeegee 171 will be described as a representative.

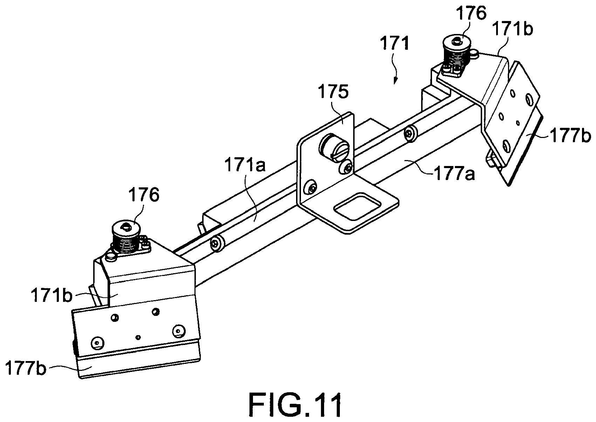

Fig. 11 is a schematic perspective view showing the squeegee 171. The squeegee 171 includes an attachment portion 175, a main squeegee 171a, and a pair of sub-squeegees 171b. The attachment portion 175 is attached to the squeegee mechanism 170. The pair of the sub-squeegees 171b is provided on both ends of the main squeegee 171a. The main squeegee 171a and the sub-squeegees 171b are connected through spring members 176. The sub-squeegees 171b are movable vertically with respect to the main squeegee 171a. A squeegee surface 177a of the main squeegee 171a that is brought into contact with the screen 1 is inclined with respect to the screen 1 by a predetermined angle. Further, squeegee surfaces 177b of the pair of sub-squeegees 171b are also inclined with respect to the screen 1 by a predetermined angle.

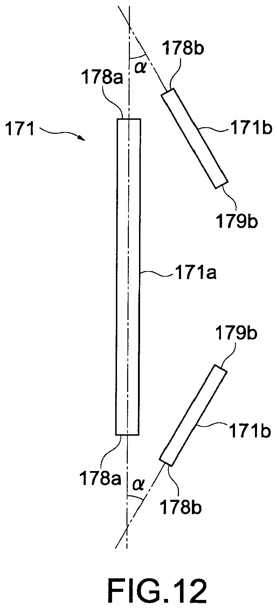

Fig. 12 is a schematic top view showing the squeegee 171 viewed from above. In Fig. 12, the squeegee surfaces 177a and 177b are shown as the main squeegee 171a and the sub-squeegees 171b as a matter of convenience for explanation. As shown in Fig. 12, the pair of sub-squeegees 171b is inclined by a predetermined angle α with respect to the extending direction of the main squeegee 171a. Further, outer ends 178b of the sub-squeegees 171b are positioned outside both ends 178a of the main squeegee 171a. In addition, inner ends 179b of the sub-squeegees 171b are positioned inside the both ends 178a of the main squeegees 171a.

To the fluid supply apparatus 100 or the squeegee mechanism 170, a rolling diameter detection sensor (not shown) is provided. The rolling diameter detection sensor measures a rolling diameter at the time when the solder supplied to the screen is applied. The rolling diameter detection sensor irradiates the solder with, for example, laser light or an ultrasonic wave, and detects the light or the ultrasonic wave reflected on the surface of the solder, thereby determining a curvature radius of the surface of the solder that is subjected to the rolling. The rolling diameter detection sensor may be disposed at any position, as long as the rolling diameter detection sensor is capable of measuring the rolling diameter. For example, the rolling diameter detection sensor may be provided integrally with the squeegee 171, thereby measuring the rolling diameter of the solder applied with the squeegee 172.

Further, to the fluid supply apparatus 100 or the squeegee mechanism 170, a solder temperature detection sensor (not shown) is provided. The solder temperature detection sensor measures the temperature of the surface of the solder that is subjected to the rolling. The solder temperature detection sensor detects an infrared ray radiated from the surface of the solder that is subjected to the rolling, thereby measuring the temperature of the surface of the solder. As the solder temperature detection sensor, a non-contact thermistor, a non-contact thermopile that is constituted of a plurality of thermocouples, or the like is used. The solder temperature detection sensor may be disposed at any position, as long as the solder temperature detection sensor can detect the temperature of the surface of the solder. For example, the solder temperature detection sensor may be provided at the same position as the rolling diameter detection sensor.

### (Control system of fluid applying apparatus)

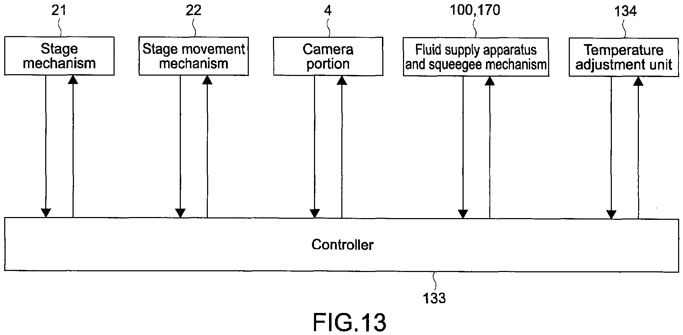

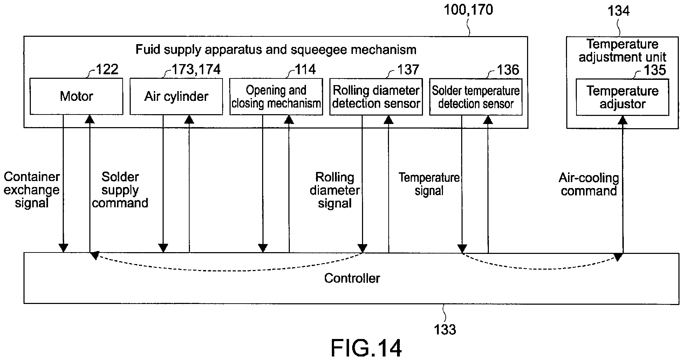

Fig. 13 is a block diagram showing the structure of a control system of the fluid applying apparatus 150. Fig. 14 is a block diagram showing a control system of the fluid supply apparatus 100 and the squeegee mechanism 170 in the block diagram shown in Fig. 13.

As shown in Figs. 13 and 14, the drives of the stage mechanism 21, the stage movement mechanism 22, the camera portion 4, the fluid supply apparatus 100, and the squeegee mechanism 170 are controlled by a controller 133. Further, in this embodiment, the controller 133 also controls a temperature adjustment unit 134 that adjusts the room temperature in which the fluid applying apparatus 150 is installed.

It should be noted that Fig. 14 shows a temperature adjustor 135 that is provided to the temperature adjustment unit 134. The temperature adjustor 135 is controlled by the controller 133, and thus the room temperature is adjusted.

For example, the controller 133 and drivers of the respective portions may be implemented by hardware or by both of software and hardware. Typically, examples of the hardware include a CPU (central processing unit), an MPU (micro processing unit), a RAM (random access memory), a ROM (read only memory), a DSP (digital signal processor), an FPGA (field programmable gate array), an ASIC (application specific integrated circuit), an NIC (network interface card), and a WNIC (wireless NIC). Various programs that constitute the software are stored in a ROM or another storage device. The controller 133 may be provided in the fluid applying apparatus 150 or may be provided in an apparatus different from the fluid applying apparatus 150. In the case where the controller 133 is provided in another apparatus, the apparatus may be caused to output a control signal to the fluid applying apparatus 150 through wired or wireless connection.

### (Operation of fluid applying apparatus)

A description will be given on an operation of the fluid applying apparatus 150 according to this embodiment. First, the operation of the fluid supply apparatus 100 that supplies the solder onto the screen 1 will be described. Then, the overall operation of the fluid applying apparatus 150 will be described.

### (Operation of fluid supply apparatus)

From the controller 133, a control signal to supply the solder is output to the driver of the motor 122 shown in Figs. 3 to 7, and the motor 122 is rotated. As a result, the driving pulley 123 is rotated, and the vertical drive pulley 126 is also rotated in conjunction with the rotation of the driving pulley 123, thereby moving the container downward. Thus, the piston 106 is relatively moved upward in the container. In conjunction with the rotation of the driving pulley 123, the rotary drive pulley 125 is also rotated. Therefore, the container moved downward is moved downward while being rotated by the rotary drive pulley 125. Accordingly, the piston 106 is moved upward while relatively rotating in the container. As a result, the solder in the container is subjected to the pressure, and the solder is supplied through the through hole 106d of the piston 106. The solder is supplied between the squeegees 171 and 172 of the squeegee mechanism 170 shown in Fig. 2.

In addition, the piston 106 is inserted into the container while the container and the piston 106 are relatively rotated, which reduces a resistance of the piston 106 with respect to the container. Therefore, for example, even when a small motor whose output is small is used as the motor 122, the piston 106 can be reliably inserted into the container. As a result, the drive mechanism 103 can be miniaturized, and the solder can be reliably supplied.

Further, in this embodiment, it is possible to use the container as it is without transferring the solder to another container. Thus, the workability at the time of applying the fluid is improved. In addition, if the solder is transferred, the solder adhered to a paddle or the like that is used for the transfer is discarded. However, in this embodiment, the discarding of the solder is not caused, which can reduce the amount of waste of the solder.

Fig. 16 is a schematic cross-sectional view showing the piston 106 and the seal member 107 that are inserted into the container. Generally, the inner shape of the container 30 is structured so that an opening area thereof is made to be smaller toward the bottom thereof. That is, as the piston 106 is inserted, the diameter of the inside of the container 30 is gradually made to be smaller.

The seal member 107 provided on the end portion 106a of the piston 106 has the outer circumferential surface 110 having a tapered shape. The outer circumferential surface 110 has elasticity, and is therefore deformed so as to fit to the inner shape of the container 30 whose diameter becomes smaller. With this structure, a solder 31 in the container 30 can be sufficiently scraped off and discharged.

When the seal member 107 as described above is provided, the resistance of the piston 106 with respect to the container 30 may be increased in some cases. In the fluid supply apparatus 100 according to this embodiment, however, the seal member 107 as described above can be provided on the end portion 106a of the piston 106, because the resistance of the piston 106 with respect to the container 30 is small.

When the control signal for stopping the supply of the solder is output to the driver of the motor 122 from the controller 133, the driver of the motor 122 drives the motor 122 to rotate in a direction reverse to the above-mentioned direction. The driving pulley 123 is also rotated in the reverse direction. In conjunction with this, the vertical drive pulley 126 and the rotary drive pulley 125 are also rotated. Thus, the piston 106 is moved in the direction of being removed from the container while the piston 106 and the container are relatively rotated in the direction reverse to the above-mentioned direction. When the piston 106 is moved in the direction of being removed from the container, the pressure applied to the solder in the container becomes smaller.

It takes time for the solder to be discharged through the nozzle 113 after the solder is subjected to the pressure. In view of this, for example, a distance by which the piston 106 is inserted is set to be longer, and the motor 122 is rotated in the reverse direction at the timing at which the discharge of the solder is stopped when a desired supply amount thereof is obtained. As a result, the time period necessary for the discharge of the solder can be reduced. As described above, the motor 122 is driven to move the piston 106 in the vertical direction, thereby making it possible to adjust the amount of the discharge of the solder. As described above, since the resistance of the piston 106 with respect to the container at the time when the piston 106 is moved is small, the piston 106 can be easily moved in the above-mentioned manner.

In addition, when the controller 133 outputs the control signal for stopping the supply of the solder to the driver of the opening and closing mechanism 114, the opening and closing mechanism 114 is driven. Then, the nozzle 113 is sandwiched between the pair of opening and closing members 115a and 115b (see, Figs. 9A and 9B) at a desired timing, thereby closing the inside flow path of the nozzle 113. As a result, the solder discharged is removed from the nozzle 113.

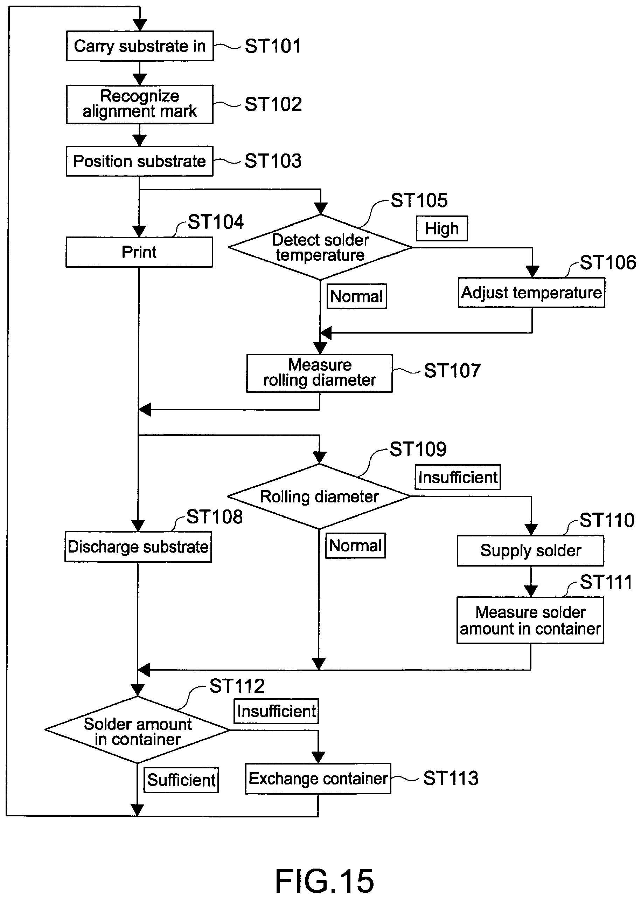

The overall operation of the fluid applying apparatus 150 will be described. Fig. 15 is a flowchart showing the operation of the fluid applying apparatus 150. The stage movement mechanism 22 is driven, and the stage movement mechanism 22 moves the stage mechanism 21 to a substrate conveying portion 29 that is provided on the camera portion 4 side shown in Fig. 2. The conveyor belt 23 of the stage mechanism 21 is driven, thereby conveying the substrate 2 from the substrate conveying portion 29 to the conveyor belt 23. After that, the stage movement mechanism 22 moves the stage mechanism 21 up to a predetermined position, and the substrate 2 is moved to a position above the adsorption block mechanism 24 with the conveyor belt 23 (Step 101).

The adsorption block mechanism 24 is moved upward to hold the substrate 2. The adsorption block mechanism 24 is connected to a vacuum pump (not shown). When the vacuum pump is operated, the adsorption block mechanism 24 adsorbs and holds the substrate 2. The substrate 2 is held up by the adsorption block mechanism 24 to an upper level as compared to the conveyor belt 23. At this time, the substrate 2 is fixed in position by a substrate fixation portion (not shown) and is pressed by the adsorption block mechanism 24, with the result that the flexure or deflection of the substrate 2 may be corrected.

The camera portion 4 is moved above the substrate 2 held by the adsorption block mechanism 24 and recognizes an alignment mark of the substrate 2 (Step 102). The positional information of the alignment mark is transmitted to the controller 133, and the stage movement mechanism 22 corrects the position of the stage mechanism 21 based on the positional information. When the position of the stage mechanism 21 is corrected, the air cylinder 26 of the stage movement mechanism 22 is caused to operate, thereby moving the stage mechanism 21 upward. The stoppers 27 of the stage movement mechanism 22 are brought into contact with the stage mechanism 21, and the stage mechanism 21 is stopped at the position where the substrate 2 is in contact with the lower surface of the screen 1 (Step 103).

In this embodiment, the stage mechanism 21 is moved so that the substrate 2 is in contact with the lower surface of the screen 1. However, the stage mechanism 21 may be moved so that the substrate 2 is disposed to be apart from the screen 1. In this case, for example, by providing a needle nozzle or the like on the lower surface of the screen 1, the solder can be supplied onto the substrate on which parts are mounted through the needle nozzle.

The controller 133 drives the air cylinders 173 and 174, to move one of the squeegees 171 and 172 upward and bring the other one into contact with the screen 1. Subsequently, the fluid supply apparatus 100 and the squeegee mechanism 170, the drives of which are controlled by the controller 133, are integrally moved. As a result, the solder is applied to the screen 1, and a predetermined solder pattern is printed on the substrate 2 (Step 104).

At a time when the squeegee mechanism 170 is moved from the right side to the left side in Fig. 2, the squeegee 172 is moved upward, and the squeegee 171 is brought into contact with the screen 1. Then, the solder is applied with the squeegee 171. At a time when the squeegee mechanism 170 is moved from the left side to the right side in Fig. 2, the squeegee 171 is moved upward, and the squeegee 172 is moved downward and brought into contact with the screen 1. The solder is applied with the squeegee 172.

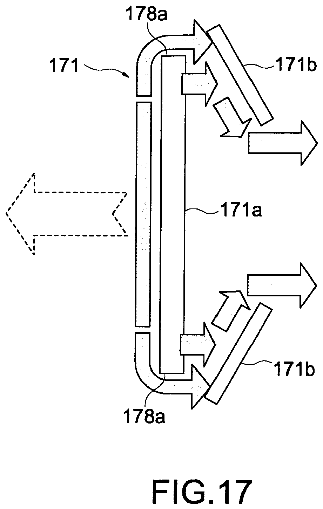

Fig. 17 is a top view schematically showing the motion of the solder when the solder is applied with the squeegee 171. When the squeegee 171 is moved in the direction indicated by the broken-line arrow of Fig. 17, in the state of being subjected to the rolling in the same direction, the solder is moved on the screen 1 with the main squeegee 171a. At this time, the solder may get outside of the both ends 178a of the main squeegee 171a (in the direction indicated by the solid-line arrow of Fig. 17). However, the pair of sub-squeegees 171b is provided to the both ends 178a of the main squeegee 171a. The sub-squeegees 171b collect the solder that has got outside of the both ends 178a toward the center of the back surface side of the main squeegee 171a. The solder collected is applied on the screen 1 with the squeegee 172 opposite to the squeegee 171 when the movement direction of the squeegee mechanism 170 is reversed, for example. With this structure, the solder that has got outside of the main squeegee 171a can be effectively reused, which can reduce the waste of the solder.

Further, in this embodiment, the fluid supply apparatus 100 can be miniaturized. Therefore, as described above, it is possible to easily realize the movement mechanism that causes the fluid supply apparatus 100 and the squeegee mechanism 170 to be integrally moved. The integral movement of the fluid supply apparatus 100 and the squeegee mechanism 170 can cause the solder to be effectively supplied at the time of applying the solder. In addition, the solder can be supplied between the squeegees 171 and 172, and thus can be effectively applied without setting the stroke of the squeegee mechanism 170 to be large.

In the fluid applying apparatus 150 according to this embodiment, the temperature of the room in which the fluid applying apparatus 150 is provided is adjusted by the temperature adjustment unit 134 (Step 105). As shown in Fig. 14, the solder temperature detection sensor 136 measures the temperature of the surface of the solder, and transmits the temperature information to the controller 133. When the controller 133 judges that the room temperature is high based on the temperature information received, the controller 133 outputs an air-cooling command to the temperature adjustor 135, thereby lowering the room temperature (Step 106). When it is judged that the room temperature is normal, the room temperature is not adjusted. In this way, the temperature of the surface of the solder is monitored, to adjust the room temperature depending on the temperature of the surface of the solder, which is raised due to the rolling. As a result, more precise control on the temperature of the solder can be carried out.

In addition, at the time when the solder is printed, the rolling diameter detection sensor 137 measures the rolling diameter (Step 107). When the rolling diameter measured is lower than a preset standard, the information is transmitted to the controller 133 as the rolling diameter information. Thus, the rolling diameter of the solder at the time when the solder is printed is monitored. During the applying of the solder, the rolling diameter detection sensor 137 may measure the rolling diameter of the solder at all times or at a predetermined timing.

Upon completion of the printing of the solder on the substrate 2, first, the stage movement mechanism 22 moves the stage mechanism 21 downward, and the substrate 2 is placed on the conveyor belt 23 of the stage mechanism 21. The substrate 2 is moved with the conveyor belt 23, and the stage mechanism 21 is moved toward a substrate discharging portion 32 provided on the cleaning portion 5 side shown in Fig. 2 with the stage movement mechanism 22. The substrate 2 is moved from the conveyor belt 23 to the substrate discharging portion 32, and the substrate discharging portion 32 discharges the substrate 2 to the outside of the fluid applying apparatus 150 (Step 108).

In this embodiment, at the time when the substrate 2 is discharged in Step 108, the solder is supplied based on the rolling diameter information transmitted to the controller 133 (Step 109). As shown in Fig. 14, the controller 133 that has received the rolling diameter information judges that the amount of the solder on the screen 1 is insufficient, and issues a solder supply command to the motor 122, to cause the solder to be supplied (Step 110). In the case where the rolling diameter information is not transmitted from the rolling diameter detection sensor 137, it is judged that the necessary amount of the solder is supplied on the screen 1, and the solder is not additionally supplied.

As described above, the rolling diameter of the solder is monitored, and the necessary amount of the solder is supplied on the screen 1, thereby keeping the rolling diameter of the solder constant. As a result, the amount of the solder filled in a pattern hole in the screen 1 is stabilized, improving the printing quality of the solder. Further, in this embodiment, since the solder is supplied not when the solder is being printed on the substrate 2 but when the substrate is discharged, the operation time can be saved.

As shown in Fig. 15, when the amount of the solder on the screen 1 is judged to be insufficient, and the solder is supplied, the motor 122 detects the amount of the solder in the container (Step 111). Since the amount of the solder in the container is determined in accordance with the amount of insertion of the piston 106 into the container, the amount of the insertion of the piston 106 is detected as the solder amount information. The amount of the insertion of the piston 106 is detected using the motor 122 such as a servomotor, on the basis of information of an encoder value or a pulse number of the motor 122. Based on the solder amount information, the motor 122 transmits a container exchange signal to the controller 133 as shown in Fig. 14.

In Step 112, in the case where the controller 133 receives the container exchange signal and judges that the amount of the solder in the container is insufficient, the fact is notified by using a buzzer, a display, or the like. As a result, after the substrate 2 is conveyed, the container is manually exchanged (Step 113). In the case where the container exchange signal is not transmitted from the motor 122, it is judged that the sufficient amount of the solder remains in the container, and thus the notification using the buzzer, the display, or the like is not performed.

It should be noted that the processes of Steps 101 to 109 are performed on the program for operating the fluid applying apparatus 150, and after the rolling diameter is judged to be insufficient in Step 109, the fluid supply apparatus 100 supplies the solder for the first time.

In this embodiment, the supply of the solder is automatically performed by the drive mechanism 103, and the exchange of the container is manually performed. Therefore, the fluid applying apparatus 150 is stopped mainly when the container is exchanged, and is not stopped when the solder is supplied. Thus, the operation time of the fluid applying apparatus 150 is saved. In addition, the inside of the fluid applying apparatus 150 is exposed to the outside mainly only when the container is exchanged, so it is possible to suppress foreign matters from adhering to the screen 1 or the substrate 2.

In this embodiment, the solder is used as the fluid. Alternatively, flux, ACP (anisotropic conductive paste), NCP (non-conductive paste), or conductive paste made of copper or the like may be used as the fluid.

### <Modified example>

The present invention is not limited to the above embodiment, and can be variously changed without departing from the gist of the present invention.

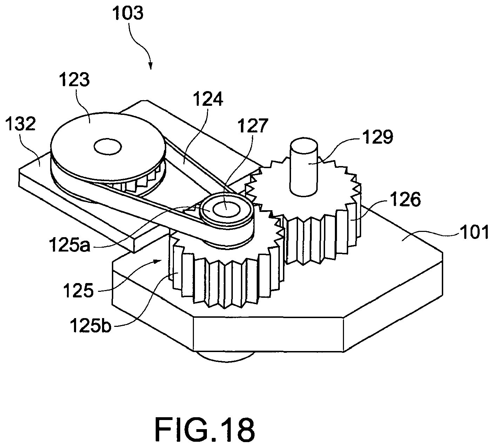

For example, Fig. 18 is a perspective view showing a modified example of the drive mechanism 103 of the fluid applying apparatus 150. In the drive mechanism 103, the rotary drive pulley 125 and the driving pulley 123 provided to the rotary shaft of the motor are connected with each other through the belt 124. The rotary drive pulley 125 is constituted of a first pulley 125a and a second pulley 125b. The first pulley 125a and the driving pulley 123 are connected with each other through the belt 124. With this structure, the driving pulley 123 and the rotary drive pulley 125 are rotated in conjunction with each other.

The first pulley 125a and the second pulley 125b share a rotary shaft 127, and the rotary shaft 127 is connected to the container support portion 104. The cogs of the second pulley 125b and the cogs of the vertical drive pulley 126 are engaged with each other, so the rotary drive pulley 125 and the vertical drive pulley 126 are rotated in conjunction with each other. The vertical drive pulley 126 is rotated about the lead screw 129 as the rotation shaft.

The structures of the pulleys 123, 125, and 126 may be arbitrarily set, as long as the pulleys 123, 125, and 126 are rotated by the motor in conjunction with one another as described above. Further, the numbers of pulleys and motors used as the drive mechanism 103 are not limited. In this embodiment, only one motor rotates the pulleys 123, 125, and 126, which is advantageous for the miniaturization of the drive mechanism 103.

Alternatively, as the drive mechanism 103, a plurality of gears may be used instead of the belt drive as described above.

In the above embodiment, the container support portion and the container are rotated. Alternatively, the container support portion may be fixed to the support block so as not to rotate, and the piston supported by the piston support portion may be rotated. With the use of the fluid supply apparatus having such a structure, the same effect as the above embodiment can also be obtained.

In addition, a discharge sensor that detects the discharge of the solder from the container may be provided to the fluid supply apparatus and the squeegee mechanism. For example, a laser emitting portion is provided to the squeegee 171 shown in Fig. 4, and a laser entering portion is provided to the squeegee 172. Then, the laser light irradiation is performed between the squeegees 171 and 172, thereby detecting the discharge of the solder.

In a container commercially available, air may be contained, for example. In the case where the container is mounted on a fluid supply apparatus for the first time, even if the motor is rotated, air is just discharged, which may prevent the solder from being discharged. In view of this, when the container is mounted for the first time, the motor is rotated at a predetermined position on the screen, and the discharge sensor confirms the discharge of the solder. Accordingly, when the fluid supply apparatus is operated, the solder is reliably supplied.

As a modified example of the fluid applying apparatus 150 described above, the structure including a squeegee block may be used. By the fluid supply apparatus 100, the solder is supplied to the squeegee block.

## Claims

1. A fluid supply apparatus (100), comprising:
a piston (106) having a through hole (106d);
a piston support portion (102) to support the piston (106);
a container support portion (104) capable of supporting a container (30) in which a fluid (31) is contained;
a drive mechanism (103) to drive at least one of the container support portion (104) and the piston support portion (102) in a direction in which the piston (106) is inserted into the container (30) at a time when supply of the fluid (31) is performed, a nozzle (113) having an inside flow path that is communicated with through hole (106d), the apparatus being **characterized in that** the nozzle (113) further includes a discharge end portion (116) including a tapered surface (116a) whose outer circumference is decreased in diameter in a direction in which the fluid is discharged;
an opening and closing mechanism is capable of opening and closing the inside flow path, the opening and closing mechanism being configured to close the inside flow path by pressing the discharge end portion; wherein said drive mechanism drives at least one of the container support portion (104) and the piston support portion (102) in a direction in which the piston (106) is relatively removed from the container (30) at a time when the supply of the fluid (31) is stopped.

2. The fluid supply apparatus according to claim 1,
wherein the piston (106) includes a seal member (107) provided at an end portion of the piston (106), the seal member (107) having a tapered outer circumferential surface whose outer circumference is increased in diameter in a direction (Z) in which the piston (106) is inserted.

3. The fluid supply apparatus (100) according to anyone of claims 1 or 2,
wherein the fluid (31) is solder.

4. The fluid supply apparatus according to any of the preceding claims,
wherein the opening and closing mechanism includes a pair of opening and closing members (115a, 115b) that presses the nozzle (113) with the nozzle (113) being sandwiched therebetween, the pair of opening and closing members (115a, 115b) each having a pressing end portion (119a, 119b) and a cutout (120a, 120b), the pressing end portion (119a, 119b) pressing the nozzle (113), the cutout (120a, 120b) being formed at the pressing end portion (119a, 119b).

5. The fluid supply apparatus (100) according to any of the preceding claims, wherein the drive mechanism (103) is configured to drive at least one of the container support portion (104) and the piston support portion (102) so that the piston is inserted into the container while the container and the piston (106) are relatively rotated to discharge the fluid from the container through the through hole of the piston (106).

6. A fluid supply method, comprising:
discharging a fluid (31), with a use of a fluid supply apparatus (100), the fluid supply apparatus (100) including a piston (106) having a through hole, a piston support portion (102), a container support portion (104), and a drive mechanism (103), a nozzle (113) having an inside flow path that is communicated with the through hole (106d), the nozzle further including a discharge end portion including a tapered surface whose outer circumference is decreased in diameter in a direction in which the fluid is discharged, from the container (30) through the through hole of the piston (106) by driving at least one of the container support portion (104) and the piston support portion (102) in a direction in which the piston (106) is inserted into the container (30), the piston support portion (102) supporting the piston (106), the container support portion (104) being capable of supporting the container (30) in which the fluid (31) is contained, the drive mechanism (103) being capable of driving at least one of the container support portion (104) and the piston support portion (102) to discharge the fluid (31) from the container; the method **characterized in that** the fluid supply apparatus (100) further comprises an opening and closing mechanism capable of opening and closing the inside flow path, the opening and closing mechanism being configured to close the inside flow path by pressing the discharge end portion, and further **characterized by** the step of: driving at least one of the container support portion (104) and the piston support portion (102) in a direction in which the piston (106) is relatively removed from the container (30) prior to stop of discharge of the fluid (31).

7. The fluid supply method according to claim 6,
wherein the fluid (31) is solder.

8. The fluid supply method according to claim 6 or 7, further comprising driving at least one of the container support portion (104) and the piston support portion (102) so that the piston (106) is inserted into the container (30) while the container (30) and the piston (106) are relatively rotated.

9. A fluid applying apparatus, comprising:
the fluid supply apparatus according to any of claims 1 to 5, and
a squeegee mechanism capable of applying, to a supply target, the fluid supplied on the supply target by the fluid supply apparatus.

10. The fluid applying apparatus according to claim 9, further comprising:
a movement mechanism to cause the fluid supply apparatus and the squeegee mechanism to integrally move.

## Patentansprüche

1. Fluidzufuhrvorrichtung (100), umfassend:
einen Kolben (106) mit einem Durchgangsloch (106d);
einen Kolbentragteil (102), um den Kolben (106) zu tragen;
einen Behältertragteil (104), der einen Behälter (30) tragen kann, in welchem ein Fluid (31) enthalten ist;
einen Antriebsmechanismus (103), um zumindest einen des Behältertragteils (104) und des Kolbentragteils (102) in einer Richtung anzutreiben, in der der Kolben (106) in den Behälter (30) eingeführt wird, zu einer Zeit, zu der eine Zufuhr des Fluids (31) ausgeführt wird;
eine Düse (113) mit einen innenliegenden Strömungsweg, der mit dem Durchgangsloch (106d) in Verbindung steht, wobei die Vorrichtung **dadurch gekennzeichnet ist, dass**
die Düse (113) ferner einen Ausstoßendteil (116) enthält, der eine konische Oberfläche (116a) umfasst, deren äußerer Umfang in einer Richtung, in der das Fluid ausgestoßen wird, im Durchmesser verringert ist;
ein Öffnungs- und Schließmechanismus imstande ist, den innenliegenden Strömungsweg zu öffnen und zu schließen, wobei der Öffnungs- und Schließmechanismus dafür eingerichtet ist, den innenliegenden Strömungsweg durch Pressen des Ausstoßendteils zu schließen, wobei der Antriebsmechanismus zumindest einen des Behältertragteils (104) und des Kolbentragteils (106) in einer Richtung antreibt, in der der Kolben (106) aus dem Behälter (30) relativ entfernt wird, zu einer Zeit, zu der die Zufuhr des Fluids (31) gestoppt wird.

2. Fluidzufuhrvorrichtung nach Anspruch 1,
wobei der Kolben (106) ein an einem Endteil des Kolbens (106) vorgesehenes Dichtungselement (107) enthält, wobei das Dichtungselement (107) eine konische äußere Umfangsfläche aufweist, deren äußerer Umfang in einer Richtung (Z), in der der Kolben (106) eingeführt wird, im Durchmesser vergrößert ist.

3. Fluidzufuhrvorrichtung (100) nach einer der Ansprüche 1 oder 2, wobei das Fluid (31) ein Lot ist.

4. Fluidzufuhrvorrichtung nach einem der vorhergehenden Ansprüche,
wobei der Öffnungs- und Schließmechanismus ein Paar Öffnungs- und Schließelemente (115a, 115b) enthält, das die Düse (113) presst, wobei die Düse (113) dazwischen angeordnet ist, wobei die beiden Öffnungs- und Schließelemente (115a, 115b) jeweils einen pressenden Endteil (119a, 119b) und einen Ausschnitt (120a, 120b) aufweisen, wobei der pressende Endteil (119a, 119b) die Düse (113) presst, wobei der Ausschnitt (120a, 120b) bei dem pressenden Endteil (119a, 119b) ausgebildet ist.

5. Fluidzufuhrvorrichtung (100) nach einem der vorhergehenden Ansprüche, wobei der Antriebsmechanismus (103) dafür eingerichtet ist, zumindest einen des Behältertragteils (104) und des Kolbentragteils (106) so anzutreiben, dass der Kolben in den Behälter eingeführt wird, während der Behälter und der Kolben (106) relativ gedreht werden, um das Fluid aus dem Behälter durch das Durchgangsloch (106d) des Kolbens (106) auszustoßen.

6. Fluidzufuhrverfahren, umfassend:
Ausstoßen eines Fluids (31) unter Verwendung einer Fluidzufuhrvorrichtung (100), wobei die Fluidzufuhrvorrichtung (100) einen Kolben (106) mit einem Durchgangsloch, einen Kolbentragteil (102), einen Behältertragteil (104) und einen Antriebsmechanismus (103) enthält, wobei eine Düse (113) einen innenliegenden Strömungsweg aufweist, der mit dem Durchgangsloch (106d) in Verbindung steht, wobei die Düse ferner einen Ausstoßendteil enthält, der eine konische Oberfläche umfasst, deren äußerer Umfang in einer Richtung im Durchmesser verringert ist, in der das Fluid ausgestoßen wird, aus dem Behälter (30) durch das Durchgangsloch des Kolbens (106), indem zumindest einer des Behältertragteils (104) und des Kolbentragteils (102) in einer Richtung angetrieben wird, in der der Kolben (106) in den Behälter (30) eingeführt wird, wobei der Kolbentragteil (102) den Kolben (106) trägt, wobei der Behältertragteil (104) den Behälter (30) tragen kann, in welchem das Fluid (31) enthalten ist, wobei der Antriebsmechanismus (103) imstande ist, zumindest einen des Behältertragteils (104) und des Kolbentragteils (102) anzutreiben, um das Fluid (31) aus dem Behälter auszustoßen;
wobei das Verfahren **dadurch gekennzeichnet ist, dass** die Fluidzufuhrvorrichtung (100) ferner einen Öffnungs- und Schließmechanismus aufweist, der imstande ist, den innenliegenden Strömungsweg zu öffnen und zu schließen, wobei der Öffnungs- und Schließmechanismus dafür eingerichtet ist, den innenliegenden Strömungsweg durch Pressen des Ausstoßendteils zu schließen, und ferner **gekennzeichnet ist durch** den Schritt:
Antreiben zumindest eines des Behältertragteils (104) und des Kolbentragteils (102) in einer Richtung, in der der Kolben (106) relativ aus dem Behälter (30) vor einem Stopp eines Ausstoßes des Fluids (31) entfernt wird.

7. Fluidzufuhrverfahren nach Anspruch 6,
wobei das Fluid (31) ein Lot ist.

8. Fluidzufuhrverfahren nach Anspruch 6 oder 7, ferner umfassend ein Antreiben zumindest eines des Behältertragteils (104) und des Kolbentragteils (102), so dass der Kolben (106) in den Behälter (30) eingeführt wird, während der Behälter (30) und der Kolben (106) relativ gedreht werden.

9. Fluidauftragungsvorrichtung, umfassend:
die Fluidzufuhrvorrichtung nach einem der Ansprüche 1 bis 5, und
einen Rakelmechanismus, der imstande ist, auf ein Zufuhrziel das durch die Fluidzufuhrvorrichtung auf dem Zufuhrziel bereitgestellte Fluid aufzutragen.

10. Fluidauftragungsvorrichtung nach Anspruch 9, ferner umfassend:
einen Bewegungsmechanismus, um zu veranlassen, dass sich die Fluidzufuhrvorrichtung und der Rakelmechanismus integral bewegen.

## Revendications

1. Appareil d'alimentation en fluide (100) comprenant :
un piston (106) qui présente un perçage traversant (106d) ;
une partie de support de piston (102) pour supporter le piston (106) ;
une partie de support de récipient (104) apte à supporter un récipient (30) dans lequel est contenu un fluide (31) ;
un mécanisme d'entraînement (103) pour entraîner la partie de support de récipient (104) et/ou la partie de support de piston (102) dans une direction dans laquelle le piston (106) est introduit dans le récipient (30) à un moment où l'alimentation en fluide (31) est réalisée ;
un éjecteur (113) qui présente une trajectoire d'écoulement intérieure qui communique avec le perçage traversant (106d),
l'appareil étant **caractérisé en ce que** l'éjecteur (113) comporte également
une partie d'extrémité de décharge (116) présentant une surface effilée (116a) dont la circonférence extérieure va en diminuant, en diamètre, dans une direction dans laquelle le fluide est déchargé ;
un mécanisme d'ouverture et de fermeture est apte à ouvrir et fermer la trajectoire d'écoulement intérieure, ledit mécanisme d'ouverture et de fermeture étant conçu pour fermer la trajectoire d'écoulement intérieure en pressant la partie d'extrémité de décharge,
ledit mécanisme d'entraînement entraînant la partie de support de récipient (104) et/ou la partie de support de piston (102) dans une direction dans laquelle le piston (106) est enlevé du récipient (30) à un moment où l'alimentation en fluide (31) est arrêtée.

2. Appareil d'alimentation en fluide selon la revendication 1, dans lequel le piston (106) comporte sur une partie d'extrémité un élément d'étanchéité (107), ledit élément d'étanchéité (107) présentant une surface circonférentielle extérieure effilée dont la circonférence augmente en diamètre dans une direction (Z) dans laquelle le piston (106) est introduit.

3. Appareil d'alimentation en fluide (100) selon l'une quelconque des revendications 1 ou 2, dans lequel le fluide (31) est un métal d'apport de brasage.

4. Appareil d'alimentation en fluide selon l'une quelconque des revendications précédentes, dans lequel le mécanisme d'ouverture et de fermeture comprend deux éléments d'ouverture et de fermeture (115a, 115b) qui pressent l'éjecteur (113), placé en sandwich entre eux, ces éléments d'ouverture et de fermeture (115a, 115b) comportant chacun une partie d'extrémité de pression (119a, 119b) et une découpe (120a, 120b), ladite partie d'extrémité de pression (119a, 119b) pressant l'éjecteur (113), et la découpe (120a, 120) étant formée au niveau de la partie d'extrémité de pression (119a, 119b).

5. Appareil d'alimentation en fluide (100) selon l'une quelconque des revendications précédentes, dans lequel le mécanisme d'entraînement (103) est conçu pour entraîner la partie de support de récipient (104) et/ou la partie de support de piston (102) de telle sorte que le piston soit introduit dans le récipient alors que le récipient et le piston (106) sont soumis à une rotation relative afin de décharger le fluide à partir du récipient, par le perçage traversant du piston (106).

6. Procédé d'alimentation en fluide, comprenant :
le déchargement d'un fluide (31), à l'aide d'un appareil d'alimentation en fluide (100), l'appareil d'alimentation en fluide (100) comprenant un piston (106) qui présente un perçage traversant, une partie de support de piston (102), une partie de support de récipient (104) et un mécanisme d'entraînement (103), un éjecteur (113) qui présente une trajectoire d'écoulement intérieure qui communique avec le perçage traversant (106d), l'éjecteur comportant également une partie d'extrémité de décharge avec une surface effilée dont la circonférence extérieure va en diminuant, en diamètre, dans une direction dans laquelle le fluide est déchargé à partir du récipient (30) par le perçage traversant du piston (106) grâce à l'entraînement de la partie de support de récipient (104) et/ou de la partie de support de piston (102) dans une direction dans laquelle le piston (106) est introduit dans le récipient (30), la partie de support de piston (102) supportant le piston (106), la partie de support de récipient (104) étant apte à supporter le récipient (30) dans lequel est contenu le fluide (31), le mécanisme d'entraînement (103) étant apte à entraîner la partie de support de récipient (104) et/ou la partie de support de piston (102) afin de décharger le fluide (31) à partir du récipient ;
le procédé étant **caractérisé en ce que** l'appareil d'alimentation en fluide (100) comprend également un mécanisme d'ouverture et de fermeture apte à ouvrir et fermer la trajectoire d'écoulement intérieure, ledit mécanisme d'ouverture et de fermeture étant conçu pour fermer la trajectoire d'écoulement intérieure en pressant la partie d'extrémité de décharge,
et également **caractérisé par** l'étape :
d'entraînement de la partie de support de récipient (104) et de la partie de support de piston (102) dans une direction dans laquelle le piston (106) est enlevé du récipient (30) avant l'arrêt du déchargement du fluide (31) .

7. Procédé d'alimentation en fluide selon la revendication 6, selon lequel le fluide (31) est un métal d'apport de brasage.

8. Procédé d'alimentation en fluide selon la revendication 6 ou 7, comprenant également l'entraînement de la partie de support de récipient (104) et/ou de la partie de support de piston (102) de telle sorte que le piston (106) soit introduit dans le récipient (30) alors que ledit récipient (30) et le piston (106) sont soumis à une rotation relative.

9. Appareil d'application de fluide comprenant :
l'appareil d'alimentation en fluide selon l'une quelconque des revendications 1 à 5, et
un mécanisme racleur apte à appliquer à une cible d'alimentation le fluide amené sur celle-ci par l'appareil d'alimentation en fluide.

10. Appareil d'application de fluide selon la revendication 9, comprenant également :
un mécanisme de déplacement pour amener l'appareil d'alimentation en fluide et le mécanisme racleur à se déplacer d'un seul bloc.
